# EUROPÄISCHE PATENTSCHRIFT

(11) **EP 1 314 346 B1**
(45) Veröffentlichungstag und Bekanntmachung des Hinweises auf die Patenterteilung: **23.11.2005**
(21) Anmeldenummer: 01976103.0
(22) Anmeldetag: 17.08.2001
(51) Int. Cl.: H05K 7/14

(54) **BEFESTIGUNGSELEMENT ZUR VERBINDUNG VON FLACHBAUTEILEN UND BAUGRUPPENTRÄGER ZUR AUFNAHME VON STECKBAUGRUPPEN MIT EINEM DERARTIGEN BEFESTIGUNGSELEMENT**
FASTENING ELEMENT FOR CONNECTING FLAT COMPONENTS AND A SUB-RACK FOR RECEIVING PLUG-IN MODULES COMPRISING SAID FASTENING ELEMENT
ELEMENT DE FIXATION DESTINE A L'ASSEMBLAGE DE COMPOSANTS PLATS, ET SUPPORT D'ENSEMBLE DESTINE AU LOGEMENT D'ENSEMBLES ENFICHABLES AU MOYEN DUDIT ELEMENT DE FIXATION

(30) Priorität: 18.08.2000 DE 20014272 U
(43) Veröffentlichungstag der Anmeldung: 28.05.2003
(73) Patentinhaber: Rittal Electronic Systems GmbH & Co. KG, 35745 Herborn (DE)
(72) Erfinder: KOERBER, Werner, 91282 Betzenstein (DE); SCHAFFER, Kurt-Michael, 90542 Eckental (DE)
(74) Vertreter: Fleck, Hermann-Joseph
(86) Internationale Anmeldenummer: PCT/EP2001/009523
(87) Internationale Veröffentlichungsnummer: WO 2002/017697

(56) Entgegenhaltungen:
- DE-U- 29 618 629
- DE-U- 29 719 220
- DE-U- 29 819 941

## Beschreibung

Die Erfindung betrifft ein Befestigungselement zur Verbindung von Flachbauteilen, insbesondere zur Verbindung einer Seitenwand und eines Deckbleches eines Baugruppenträgers zur Aufnahme von mit elektrischen oder elektronischen Bauteilen bestückten Steckbaugruppen, wobei das Befestigungselement eine mit dem ersten Flachbauteil verbindbare Rückseite, einen auf der Oberseite des zweiten Flachbauteils anliegenden Halteschenkel und einen mit der Rückseite gekoppeltem Klemmschenkel aufweist, der sich an dem zweiten Flachbauteil abstützt und mit diesem verspannbar ist, wozu ein Verbindungselement durch das erste Flachbauteil und die Rückseite des Befestigungselementes eingeführt und mit dem Klemmschenkel verschraubt ist, wobei das freie Ende des Klemmschenkels an der Unterseite des zweiten Flachbauteiles abstützt und mit dem Anbringen des Verbindungselementes der Klemmschenkel mit dem zweiten Flachbauteil verspannt und/oder kontaktiert ist.

Ein Befestigungselement dieser Art ist aus der DE 298 19 941 U1 bekannt.

Bei diesem bekannten Befestigungselement ist die Handhabung bei der Herstellung der Verbindung mit Schwierigkeiten verbunden, da die untereinander zu verbindenden Bauteile eine mehr oder weniger große Verstellbewegung ausführen. Der wesentliche Nachteil besteht jedoch darin, dass die Klemmkraft der Verbindung nicht angepaßt werden kann.

Diese Aufgabe wird nach der Erfindung dadurch gelöst, dass die Rückseite des Befestigungselementes an der Innenseite des ersten Flachbauteiles anliegt, und dass der Klemmschenkel eine Schraubaufnahme (oder eine Gewindeaufnahme) aufweist, die mit dem Verbindungselement zusammenwirkt, so dass der Klemmschenkel durch eindrehen des Verbindungselementes in die Schraubaufnahme in Klemmrichtung angezogen wird.

Bei dieser Ausgestaltung erfüllt das Befestigungselement zwei Funktionen. Zum einen wird das Befestigungselement mit dem ersten Flachbauteil verbunden und zum anderen wird mit dem Klemmschenkel eine Klemmkraft auf das zweite Flachbauteil ausgeübt, die abhängig ist von dem Anzugsweg des Klemmschenkels. Auf diese Weise wird eine sichere Befestigung und Kontaktierung der beiden miteinander verbundenen Flachbauteile erreicht, die in der Klemmkraft auf einfache Weise allein durch ein mehr oder weniger großes Anziehen des Befestigungselementes erreicht wird.

Das erste und zweite Flachbauteil sind insbesondere als Seitenwand und Deckblech eines z. B. in der DE 296 18 629 U1 beschriebenen Baugruppenträgers zur Aufnahme von mit elektrischen oder elektronischen Bauteilen bestückten Steckbaugruppen ausgebildet. Dabei dient das erfindungsgemäße Befestigungselement zur sicheren Verbindung von Deckblechen und Seitenwänden derartiger Baugruppenträger.

Als Verbindungselement kann für eine lösbare Verbindung z. B. eine Befestigungsschraube oder ein Spannverschluss (Exzenter) und für eine unlösbare Verbindung z. B. ein Nietelement verwendet werden.

Vorteilhafterweise besitzt der Klemmschenkel des Befestigungselementes einen Endbereich der gebogen oder gekantet ausgebildet ist, wodurch eine sichere Kontaktierung und Erfassung eines aufgenommenen zweites Flachbauteils an dessen Unterseite beim Anbringen des Verbindungselementes stattfindet.

Wenn das Befestigungselement mehrere Öffnungen und/oder mehrere Aufnahmen aufweist, können mehrere aufgenommene zweite Flachbauteile besonders zuverlässig an den zugehörigen ersten Flachbauteilen angebracht werden.

Vorteilhafterweise besitzt der Klemmschenkel einen gebogenen oder gekanteten Endbereich um eine Beschädigung eines aufgenommenen zweiten Flachbauteils zu vermeiden.

Wenn der Klemmschenkel in seiner entspannten Ruhestellung beabstandet vom Halteschenkel angebracht ist, kann das aufzunehmende zweite Flachbauteil montagefreundlich in einen vorliegenden Abstand zwischen Klemm- und Halteschenkel eingeführt werden. Beim Anbringen des Verbindungselements kann dann dieser Abstand verringert und vollständig beseitigt werden, so dass der Klemmschenkel das zweite Flachbauteil an dessen Unterseite kontaktiert und sicher klemmend erfasst.

Vorteilhafterweise besitzt das Befestigungselement einen Anschlag, der insbesondere zur Auflage auf dem ersten Flachbauteil dient. Dadurch wird das Befestigungselement sicher am und auf dem ersten Flachbauteil positioniert.

Ferner kann eine komplette Baueinheit gebildet werden, welche aus einem zweiten Flachbauteil mit an seinen Endbereichen bereits angeordneten und vormontierten Befestigungselementen besteht. Letztere werden zwischen zwei seitliche erste Flachbauteile lagerichtig und positionsgenau eingeführt und insbesondere durch vorliegende Anschläge auf den ersten Flachbauteilen angesetzt und danach mit Verbindungselementen wie beschrieben verbunden.

Der erfindungsgemäße Baugruppenträger gemäß Patentanspruch 21 besitzt ein Befestigungselement zur sicheren Verbindung von Seitenwänden (erstes Flachbauteil) und Deckblechen (zweites Flachbauteil) derartiger Baugruppenträger.

Die Erfindung ist mit weiteren Einzelheiten anhand von Ausführungsbeispielen in den Zeichnungsfiguren näher erläutert.
Es zeigen:
- FIG 1: einen Befestigungselement mit aufgenommenem ersten und zweiten Flachbauteil und entspanntem Klemmschenkel;
- FIG 2: einen Befestigungselement gemäß FIG 1 mit angezogenem Klemmschenkel;
- FIG 3: eine perspektivische Darstellung eines Befestigungselements;
- FIG 4: eine seitliche Ansicht des Befestigungselements nach FIG 3 sowie
- FIG 5: eine Rückansicht des Befestigungselements nach FIG 3 sowie
- FIG 6: eine weitere Ausführungsform eines Befestigungselements.

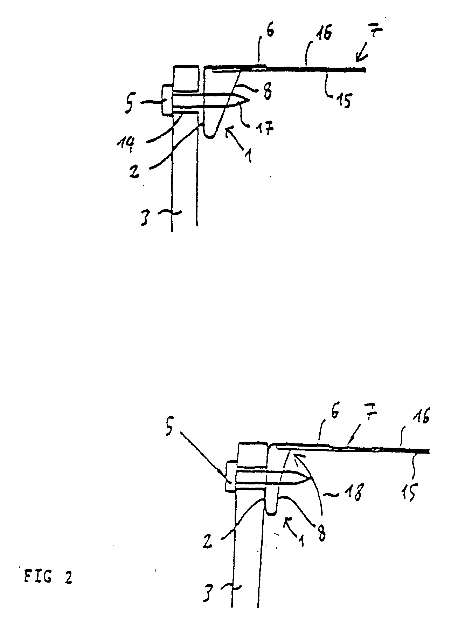

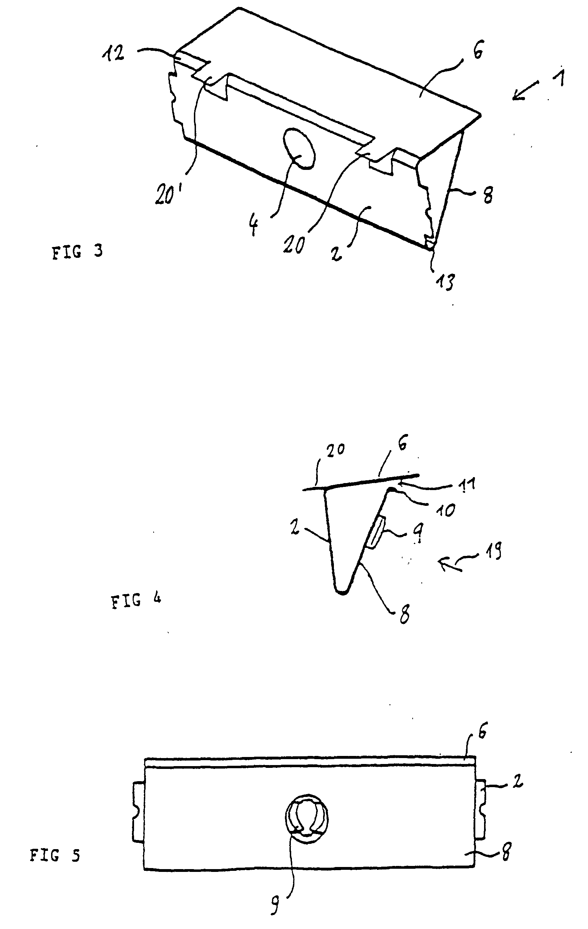

FIG 1 zeigt ein schematisch dargestelltes Befestigungselement 1 zur Verbindung eines ersten Flachbauteils 3 (z.B. einer Seitenwand eines Baugruppenträgers) mit einem winkelig hierzu angeordneten zweiten Flachbauteil 7 (z.B. einem Deckblech eines Baugruppenträgers). Das zweite Flachbauteil 7 ist im Abstand 11 (vgl. FIG 4) zwischen dem Halteschenkel 6 und dem Klemmschenkel 8 des Befestigungselements 1 eingeschoben.

Das Verbindungselement 5 ist durch eine Bauteilöffnung 14 des ersten Flachbauteils 3 und die Öffnung 4 (vgl. FIG 3) in der Rückseite 2 des Befestigungselements 1 hindurch in die Aufnahme 9 des Befestigungselements 1 eingeführt, ohne dass der Klemmschenkel 8 bereits angezogen wurde.

FIG 2 zeigt eine Darstellung nach FIG 1 mit angezogenem Klemmschenkel 8, welcher sich daraufhin bogenförmig erstreckt und mit seinem Endbereich 10 (vgl. FIG 4) die Unterseite 15 des zweiten Flachbauteils 7 kontaktiert und damit die Oberseite 16 des zweiten Flachbauteils 7 an den Halteschenkel 6 anpresst. Hierdurch wird das zweite Flachbauteil 7 klemmend und zuverlässig erfasst und mit dem ersten Flachbauteil 3 verbunden.

Wenn die Aufnahme 9 z.B. als Schraubenaufnahme (Gewinde) und das Verbindungselement 5 als Befestigungsschraube ausgebildet sind, wird der Klemmschenkel 8 durch Eindrehen der Befestigungsschraube in die Schraubenaufnahme wie in FIG 2 abgebildet in Klemmrichtung 18 angezogen.

Bei Verwendung eines Nietelements als Verbindungselement 5 wird der Klemmschenkel 8 beim Aufspreizen des Endbereichs 17 des Verbindungselement 5 ebenfalls wie in FIG 2 abgebildet in Klemmrichtung 18 herangezogen.

Gemäß FIG 3 kann das Befestigungselement 1 als gebogenes Stanzteil ausgebildet sein und besteht teilweise oder vollständig aus federelastischem Material. In der Ausführungsform nach FIG 3 besitzt das Befestigungselement 1 - anders als in FIG 1 und FIG 2 - Anschläge 20 und 20'zur Auflage auf einem ersten Flachbauteil 3. Der Halteschenkel 6 des Befestigungselements 1 geht über einen abgerundeten Übergangsbereich 12 in die Rückseite 2 über, welche über einen abgerundeten Übergangsbereich 13 sich in den Klemmschenkel 8 erstreckt.

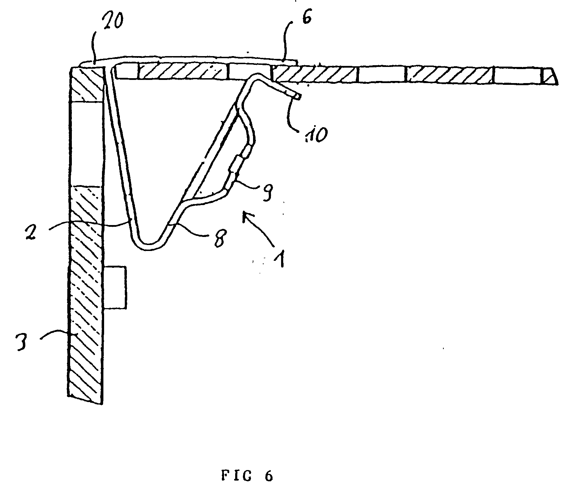

Die Rückseite 2 und der Halteschenkel 6 des Befestigungselements 1 sind im unverbauten (entspannten) Zustand in einem Winkel von etwa 90° oder kleiner (vgl. auch FIG 6), Klemmschenkel 8 und die Rückseite 2 des Befestigungselements 1 in einem Winkel von etwa 30°-45° (vgl. auch FIG 6) zueinander angeordnet. Bei Überführung des Klemmschenkels 8 in den Befestigungszustand in Klemmrichtung 18 gemäß FIG 2 verringert sich der Winkel zwischen dem Klemmschenkel 8 und der Rückseite 2.

Das Befestigungselement 1 kann auch durch die Verbindung einzelner Elemente z.B. durch Schweißung oder als Wickelteil mit seinem Halteschenkel 6 einteilig mit dem zweiten Flachbauteil 7 verbunden sein, wobei die Rückseite 2 und der Klemmschenkel 8 entsprechend abgebogen angebracht wären (nicht abgebildet). Der Klemmschenkel 8 würde dann bei angebrachtem Verbindungselement 5 das zweite Flachbauteil 7 mit Druck beaufschlagen und eine Vorspannung des eingeführten Verbindungselements 5 bewirken.

Aus FIG 4 geht ein abgerundeter Endbereich 10 des Klemmschenkels 8 hervor. In den Abstand 11 zwischen Klemmschenkel 8 und Halteschenkel 6 kann das nicht abgebildete zweite Flachbauteil 7 schonend eingeschoben und gegebenenfalls wieder demontiert werden.

In FIG 5 ist eine Rückansicht des Befestigungselements 1 aus Richtung 19 nach FIG 4 abgebildet und ist der Klemmschenkel 6 mit Aufnahme 9 dargestellt. Das Befestigungselement 1 kann auch mehrere Öffnungen 4 mit korrespondierenden Aufnahmen 9 aufweisen (nicht abgebildet).

FIG 6 zeigt ein Befestigungselement 1 gemäß FIG 3 mit einem Anschlag 20, welcher auf dem ersten Flachbauteil 3 aufliegt und als rückseitige Verlängerung des Klemmschenkels 6 ausgebildet ist. Bei dem abgebildeten Befestigungselement 1 ist der Winkel zwischen dem Halteschenkel 6 und der Rückseite 2 kleiner als 90° (nämlich etwa 80°) und ist auch der Winkel zwischen dem Klemmschenkel 8 und der Rückseite 2 kleiner als 45° (nämlich etwa 30°). Die Darstellung nach FIG 6 ist ohne Verbindungselement 5 abgebildet. Das zweite Flachbauteil 7 besitzt Ausnehmungen 21, in welche z.B. der Endbereich 10 des Klemmschenkels 8 eingreift, wodurch eine besonders sichere Verbindung zwischen erstem Flachbauteil 3 und zweitem Flachbauteil 7 hergestellt wird.

## Patentansprüche

1. Befestigungselement zur Verbindung von Flachbauteilen, insbesondere zur Verbindung einer Seitenwand und eines Deckbleches eines Baugruppenträgers zur Aufnahme von mit elektrischen oder elektronischen Bauteilen bestückten Steckbaugruppen, wobei das Befestigungselement (1) eine mit dem ersten Flachbauteil (3) verbindbare Rückseite (2), einen auf der Oberseite des zweiten Flachbauteils (7) aufliegenden Halteschenkel (6) und einen mit der Rückseite (2) gekoppeltem Klemmschenkel (8) aufweist, der sich an dem zweiten Flachbauteil (7) abstützt und mit diesem verspannbar ist, wozu ein Verbindungselement (5) durch das erste Flachbauteil (3) und die Rückseite (2) des Befestigungselementes eingeführt und mit dem Klemmschenkel (8) verschraubt ist, wobei das freie Ende des Klemmschenkels (8) an der Unterseite des zweiten Flachbauteiles (7) abstützt und mit dem Anbringen des Verbindungselementes (114) der Klemmschenkel (8) mit dem zweiten Flachbauteil (7) verspannt und/oder kontaktiert ist,
**dadurch gekennzeichnet,**
**dass** die Rückseite des Befestigungselementes an der Innenseite des ersten Flachbauteiles (3) anliegt, und
**dass** der Klemmschenkel eine Schraubaufnahme, oder eine Gewindeaufnahme (9) aufweist, die mit dem Verbindungselement (5) zusammenwirkt, so dass der Klemmschenkel (8) durch eindrehen des Verbindungselementes (5) in die Schraubaufnahme (9) in Klemmrichtung angezogen wird.

2. Befestigungselement nach Anspruch 1,
**dadurch gekennzeichnet, dass** das Verbindungselement (5) zur Herstellung einer lösbaren Verbindung dient und z.B. eine Befestigungsschraube oder ein Spannverschluss ist.

3. Befestigungselement nach Anspruch 1 oder 2,
**dadurch gekennzeichnet, dass** das Verbindungselement (5) zur Herstellung einer unlösbaren Verbindung dient und z.B. ein Nietelement ist.

4. Befestigungselement nach einem der vorhergehenden Ansprüche,
**dadurch gekennzeichnet, dass** die Rückseite (2) und der Halteschenkel (6) in einem Winkel von etwa 90° zueinander angeordnet sind.

5. Befestigungselement nach einem der Ansprüche 1 - 3,
**dadurch gekennzeichnet, dass** die Rückseite (2) und der Halteschenkel (6) in einem Winkel von weniger als 90° zueinander angeordnet sind.

6. Befestigungselement nach einem der vorhergehenden Ansprüche,
**dadurch gekennzeichnet, dass** der Klemmschenkel (8) und die Rückseite (2) im unverbauten Zustand winklig zueinander angeordnet sind.

7. Befestigungselement nach Anspruch 6,
**dadurch gekennzeichnet, dass** der Klemmschenkel (8) und die Rückseite (2) im unverbauten Zustand in einem Winkel von etwa 30° - 45° zueinander angeordnet sind.

8. Befestigungselement nach einem der vorhergehenden Ansprüche,
**dadurch gekennzeichnet, dass** der Klemmschenkel (8) einen Endbereich (10) zur Kontaktierung des zweiten Flachbauteils (7) aufweist.

9. Befestigungselement nach Anspruch 8,
**dadurch gekennzeichnet, dass** der Endbereich (10) gebogen ausgebildet ist.

10. Befestigungselement nach Anspruch 8,
**dadurch gekennzeichnet, dass** der Endbereich (10) gekantet ausgebildet ist.

11. Befestigungselement nach einem der vorhergehenden Ansprüche,
**dadurch gekennzeichnet, dass** zwischen dem Klemmschenkel (8) und dem Halteschenkel (6) ein Abstand (11) zur Einführung des zweiten Flachbauteils (7) vorgesehen ist.

12. Befestigungselement nach einem der vorhergehenden Ansprüchen,
**dadurch gekennzeichnet, dass** die Rückseite (2) mehrere Öffnungen (4) zur Durchführung von Verbindungselementen (5) aufweist.

13. Befestigurigselement nach Anspruch 12,
**dadurch gekennzeichnet, dass** der Klemmschenkel (8) mehrere Aufnahmen (9) für Verbindungselemente (5) aufweist.

14. Befestigungselement nach einem der vorhergehenden Ansprüche,
**dadurch gekennzeichnet, dass** das Befestigungselement (1) als Stanzteil ausgebildet ist.

15. Befestigungselement nach einem der vorhergehenden Ansprüche,
**dadurch gekennzeichnet, dass** der Übergangsbereich (12) zwischen Halteschenkel (6) und Rückseite (2) abgerundet ausgebildet ist.

16. Befestigungselement nach einem der vorhergehenden Ansprüche,
**dadurch gekennzeichnet, dass** der Übergangsbereich (13) zwischen Rückseite (2) und Klemmschenkel (8) abgerundet ausgebildet ist.

17. Befestigungselement nach einem der vorhergehenden Ansprüche,
**dadurch gekennzeichnet, dass** das Befestigungselement einen Anschlag (20) zur Auflage auf dem ersten Flachbauteil (3) aufweist.

18. Befestigungselement nach Anspruch 17,
**dadurch gekennzeichnet, dass** der Anschlag (20) als Verlängerung des Halteschenkels (6) ausgebildet ist.

19. Befestigungselement nach einem der vorhergehenden Ansprüche,
**dadurch gekennzeichnet, dass** der Halteschenkel (6) lösbar mit dem zweiten Flachbauteil (7) verbunden ist.

20. Befestigungselement nach einem der Ansprüche 1 - 18,
**dadurch gekennzeichnet, dass** der Halteschenkel (6) einteilig mit dem zweiten Flachbauteil (7) verbunden ist.

21. Baugruppenträger zur Aufnahme von mit elektrischen oder elektronischen Bauteilen bestückten Steckbaugruppen mit Seitenwänden und mindestens einem mit den Seitenwänden verbundenen Deckblech,
**gekennzeichnet durch** ein Befestigungselement (1) nach einem der Ansprüche 1 - 20 zur Verbindung von Seitenwand und Deckblech.

## Claims

1. Fastening element for connecting flat components, in particular for connecting a side wall and a cover plate of a mounting rack for holding plug-in modules populated by electrical or electronic components, the fastening element (1) having a rear face (2) which can be connected to the first flat component (3), a retaining limb (6) which rests on the upper face of the second flat component (7), and a clamping limb (8) which is coupled to the rear face (2) and is supported against and can be clamped to the second flat component (7), and, to this end, a connecting element (5) being inserted through the first flat component (3) and the rear face (2) of the fastening element and being screwed to the clamping limb (8), with the free end of the clamping limb (8) being supported against the lower face of the second flat component (7) and being clamped to and/or making contact with the second flat component (7) by the connecting element (5) being attached to the clamping limb (8),
**characterized**
**in that** the rear face of the fastening element rests against the inner face of the first flat component (3), and
**in that** the clamping limb has a screw mount (or a threaded mount) (9) which interacts with the connecting element (5) so that the clamping limb (8) is pulled in the clamping direction by the connecting element (5) being screwed into the screw mount (9).

2. Fastening element according to Claim 1,
**characterized in that** the connecting element (5) serves the purpose of producing a detachable connection and is, for example, a fastening screw or a tightening closure.

3. Fastening element according to Claim 1 or 2,
**characterized in that** the connecting element (5) serves the purpose of producing a fixed connection and is, for example, a rivet element.

4. Fastening element according to one of the preceding claims,
**characterized in that** the rear face (2) and the retaining limb (6) are arranged at an angle of approximately 90° to one another.

5. Fastening element according to one of Claims 1-3,
**characterized in that** the rear face (2) and the retaining limb (6) are arranged at an angle of less than 90° to one another.

6. Fastening element according to one of the preceding claims,
**characterized in that** the clamping limb (8) and the rear face (2) are arranged at an angle to one another in the unassembled state.

7. Fastening element according to Claim 6,
**characterized in that** the clamping limb (8) and the rear face (2) are arranged at an angle of approximately 30° - 45° to one another in the unassembled state.

8. Fastening element according to one of the preceding claims,
**characterized in that** the clamping limb (8) has an end region (10) for making contact with the second flat component (7).

9. Fastening element according to Claim 8,
**characterized in that** the end region (10) is bent.

10. Fastening element according to Claim 8,
**characterized in that** the end region (10) is flanged.

11. Fastening element according to one of the preceding claims,
**characterized in that** a space (11) for inserting the second flat component (7) is provided between the clamping limb (8) and the retaining limb (6).

12. Fastening element according to one of the preceding claims, **characterized in that** the rear face (2) has a plurality of openings (4) for connecting elements (5) to pass through.

13. Fastening element according to Claim 12,
**characterized in that** the clamping limb (8) has a plurality of mounts (9) for connecting elements (5).

14. Fastening element according to one of the preceding claims,
**characterized in that** the said fastening element (1) is in the form of a stamped part.

15. Fastening element according to one of the preceding claims,
**characterized in that** the transition region (12) between the retaining limb (6) and the rear face (2) is rounded.

16. Fastening element according to one of the preceding claims,
**characterized in that** the transition region (13) between the rear face (2) and the clamping limb (8) is rounded.

17. Fastening element according to one of the preceding claims,
**characterized in that** the said fastening element has a stop (20) for resting on the first flat component (3).

18. Fastening element according to Claim 17,
**characterized in that** the stop (20) is in the form of an extension of the retaining limb (6).

19. Fastening element according to one of the preceding claims,
**characterized in that** the retaining limb (6) is detachably connected to the second flat component (7).

20. Fastening element according to one of Claims 1-18,
**characterized in that** the retaining limb (6) is integrally connected to the second flat component (7).

21. Mounting rack for holding plug-in modules populated by electrical or electronic components and having side walls and at least one cover plate which is connected to the side walls,
**characterized by** a fastening element (1) according to one of Claims 1-20 for connecting a side wall and the cover plate.

## Revendications

1. Élément de fixation pour assembler des composants plats, notamment pour assembler une paroi latérale et une tôle de couverture d'un support de modules en vue d'accueillir des modules enfichables équipés de composants électriques ou électroniques, l'élément de fixation (1) présentant un côté arrière (2) pouvant être relié avec le premier composant plat (3), un montant d'arrêt (6) reposant sur le dessus du deuxième composant plat (7) et un montant de serrage (8) couplé avec le côté arrière (2), lequel s'appuie sur le deuxième composant plat (7) et peut être amarré avec celui-ci, un élément d'assemblage (5) étant introduit à cet effet à travers le premier composant plat (3) et le côté arrière (2) de l'élément de fixation et étant fixé par vissage au montant de serrage (8), l'extrémité libre du montant de serrage (8) s'appuyant sur le côté inférieur du deuxième composant plat (7) et le montant de serrage (8) étant amarré et/ou mis en contact avec le deuxième composant plat (7) en appliquant l'élément d'assemblage (5), **caractérisé en ce que** le côté arrière de l'élément de fixation repose sur le côté intérieur du premier composant plat (3) et que le montant de serrage présente un logement pour vis (ou un logement pour filet) (9) qui agit conjointement avec l'élément d'assemblage (5) de manière à ce que le montant de serrage (8) soit serré en vissant l'élément d'assemblage (6) dans le logement pour vis (9) dans le sens du serrage.

2. Élément de fixation selon la revendication 1, **caractérisé en ce que** l'élément d'assemblage (5) sert à réaliser un assemblage démontable et il est une vis de fixation ou une fermeture à genouillère, par exemple.

3. Élément de fixation selon la revendication 1 ou 2, **caractérisé en ce que** l'élément d'assemblage (5) sert à réaliser un assemblage non démontable et il est un élément de rivetage, par exemple.

4. Élément de fixation selon l'une des revendications précédentes, **caractérisé en ce que** le côté arrière (2) et le montant d'arrêt (6) sont disposés selon un angle d'environ 90° l'un par rapport à l'autre.

5. Élément de fixation selon l'une des revendications 1-3, **caractérisé en ce que** le côté arrière (2) et le montant d'arrêt (6) sont disposés selon un angle de moins de 90° l'un par rapport à l'autre.

6. Élément de fixation selon l'une des revendications précédentes, **caractérisé en ce que** le montant de serrage (8) et le côté arrière (2), en position non montée, sont disposés selon un certain angle l'un par rapport à l'autre.

7. Élément de fixation selon la revendication 6, **caractérisé en ce que** le montant de serrage (8) et le côté arrière (2), en position non montée, sont disposés selon un angle d'environ 30° à 45° l'un par rapport à l'autre.

8. Élément de fixation selon l'une des revendications précédentes, **caractérisé en ce que** le montant de serrage (8) présente une zone d'extrémité (10) pour établir le contact avec le deuxième composant plat (7).

9. Élément de fixation selon la revendication 8, **caractérisé en ce que** la zone d'extrémité (10) est de forme coudée.

10. Élément de fixation selon la revendication 8, **caractérisé en ce que** la zone d'extrémité (10) est de forme inclinée.

11. Élément de fixation selon l'une des revendications précédentes, **caractérisé en ce qu'**entre le montant de serrage (8) et le montant d'arrêt (6) est prévu un écart (11) pour introduire le deuxième composant plat (7).

12. Élément de fixation selon l'une des revendications précédentes, **caractérisé en ce que** le côté arrière (2) présente plusieurs ouvertures (4) pour le passage d'éléments d'assemblage (5).

13. Élément de fixation selon la revendication 12, **caractérisé en ce que** le montant de serrage (8) présente plusieurs logements (9) pour des éléments d'assemblage (5).

14. Élément de fixation selon l'une des revendications précédentes, **caractérisé en ce que** l'élément de fixation (1) est réalisé sous la forme d'une pièce découpée.

15. Élément de fixation selon l'une des revendications précédentes, **caractérisé en ce que** la zone de transition (12) entre le montant de maintien (6) et le côté arrière (2) est de forme arrondie.

16. Élément de fixation selon l'une des revendications précédentes, **caractérisé en ce que** la zone de transition (13) entre le côté arrière (2) et le montant de serrage (8) est de forme arrondie.

17. Élément de fixation selon l'une des revendications précédentes, **caractérisé en ce que** l'élément de fixation présente une butée (20) destinée à être appliquée sur le premier composant plat (3).

18. Élément de fixation selon la revendication 17, **caractérisé en ce que** la butée (20) est réalisée sous la forme d'une prolongation du montant de maintien (6).

19. Élément de fixation selon l'une des revendications précédentes, **caractérisé en ce que** le montant de maintien (6) est relié de manière amovible avec le deuxième composant plat (7).

20. Élément de fixation selon l'une des revendications 1-18, **caractérisé en ce que** le montant de maintien (6) est relié d'une seule pièce avec le deuxième composant plat (7).

21. Support de modules destiné à recevoir des modules enfichables équipés de composants électriques ou électroniques comprenant des parois latérales et au moins une tôle de couverture assemblée avec les parois latérales, **caractérisé par** un élément de fixation (1) selon l'une des revendications 1 à 20 pour l'assemblage de la paroi latérale et de la tôle de couverture.
